# EUROPÄISCHE PATENTANMELDUNG

(11) **EP 1 357 776 A1**
(43) Veröffentlichungstag der Anmeldung: **29.10.2003**
(21) Anmeldenummer: 03008114.5
(22) Anmeldetag: 07.04.2003
(51) Int. Cl.: H05K 7/14

(54) **Elektronisches Einbaugerät**

(30) Priorität: 26.04.2002 DE 10218891
(71) Anmelder: SIEMENS AKTIENGESELLSCHAFT, 80333 München (DE)
(72) Erfinder: Kirner, Herbert, 78052 Villingen-Schwenningen (DE)

(57) **Zusammenfassung**

Bei einem elektronischen Einbaugerät mit einer Frontwand und einem aus einem Deckel, einem Boden, Seitenwänden und einer Rückwand bestehenden Einbaugehäuseteil sowie mit einer quer zur Rückwand angeordneten, mit wenigstens zwei Gehäuseelementen des Einbaugehäuseteils verbundenen und die elektronischen Baugruppen und Bauteile des Einbaugerätes sowie einen Stekkersockel tragenden Leiterplatte, wobei der Zugang zu den leiterplattenparallel ausgerichteten Kontakten des Steckersockels durch eine an der Rückwand des Einbaugehäuseteils vorgesehene Aussparung erfolgt, ist vorgesehen, dass an dem Steckersockel (2) rechtwinklig zur Richtung der Steckkontakte (51) des Steckersockels (2) Führungsflächen (57, 58, 59) ausgebildet sind, dass den Führungsflächen (57, 58, 59) des Steckersockels (2) innerhalb des Einbaugehäuseteils (5) eine rückwandparallele Führung spielfrei zugeordnet ist und dass die Durchmesser der in der Leiterplatte (3) in dem Einbaugehäuseteil (5) mittels Schrauben (21) dienenden Durchgangsbohrungen (22) um ein im wesentlichen der Summe der Herstelltoleranzen der zusammenzufügenden Bauteile entsprechendes Maß größer sind als die Schaftdurchmesser der verwendeten Schrauben (21).

## Beschreibung

Die Neuerung betrifft ein Elektronisches Einbaugerät mit einer Frontwand und einem aus einem Deckel, einem Boden, Seitenwänden und einer Rückwand bestehenden Einbaugehäuseteil sowie mit einer quer zur Rückwand angeordneten, mit wenigstens zwei Gehäuseelementen des Einbaugehäuseteils verbundenen und die elektronischen Baugruppen und Bauteile des Einbaugerätes sowie einen Steckersockel tragenden Leiterplatte, wobei der Zugang zu den leiterplattenparallel ausgerichteten Kontakten des Steckersockels durch eine an der Rückwand des Einbaugehäuseteils vorgesehene Aussparung erfolgt.

Bei einem derartigen Gerätekonzept wird, damit der vorgegebene Einbauraum maximal genutzt werden kann, die Wandstärke des vorzugsweise aus Stahlblech hergestellten Einbaugehäuseteils des Einbaügerätes relativ gering ausgebildet. D.h., das Einbaugehäuseteil bildet eine als Staub- und Griffschutz sowie als elektromagnetischer Schirm dienende Hülle und die Leiterplatte gegebenenfalls auch ein innerhalb des Einbaugehäuseteils vorgesehenes Strukturteil dienen als versteifendes Skelett. Demzufolge wirken die beim Setzen und Ziehen der das Einbaugerät mit Daten- und Stromversorgungsleitungen verbindenden Stecker auftretenden Kräfte über den Steckersockel unmittelbar auf die Leiterplatte ein, und zwar parallel zur Leiterplattenebene, was ganz allgemein gesehen schädliche Verbiegungen der Leiterplatte zur Folge haben kann. Bei dem gegebenen baulichen Konzept besteht jedoch eine besondere Gefahr darin, dass die Lötverbindungen des Steckersockels durch beim Setzen und Ziehen der Stecker entstehende Drehmomente unmittelbar belastet werden. Dies gilt wegen der relativ großen Fertigungstoleranzen bei Spritzgießteilen auch dann, wenn der Steckersockel, der in dieser Weise hergestellt ist, durch Ausrichtzapfen und Rasthaken an der Leiterplatte befestigt ist. Ist bei dem betreffenden Einbaugerät, wie beispielweise im Falle eines Fahrtschreibers, ein mit mehreren nebeneinander ausgebildeten Steckerkammern versehener Steckersockel vorgesehen, so treten beim Setzen und Ziehen der üblicherweise achtpoligen Stecker nicht nur Drehmomente quer, sondern auch parallel zur Leiterplattenebene auf. Im übrigen können beim Einbau eines Fahrtschreibers in einem Nutzfahrzeug, wo am Einbauort, d.h. im haptischen Bereich des Fahrers aufgrund der räumlich ungünstigen Einbauverhältnisse, die u. U. eine Blindmontage der Stecker erforderlich machen, erhebliche, in unterschiedlichste Richtungen wirkende Kräfte auftreten. Außerdem kann im Falle eines Fahrtschreibers nach dessen Einbau das eine erhebliche Steifigkeit aufweisende Leitungsbündel aufgrund der beim Einbau erforderlichen Umlenkungen und gegebenenfalls durch Stauchung eine stetige elastische Rückwirkung auf den Steckersockel ausüben.

Die Aufgabe der vorliegenden Neuerung best and somit darin, bei dem gattungsgemäßen Gerätekonzept schädliche Belastungen der Lötverbindungen zwischen Steckersockel und Leiterplatte durch beim Setzen und Ziehen von Steckern sowie durch den Ein- und Ausbau des Einbaugerätes entstehende Kräfte mit möglichst geringem Aufwand zu vermeiden.

Die Lösung der Aufgabe sieht vor, dass an dem Steckersockel rechtwinklig zur Richtung der Steckkontakte des Steckersockels Führungsflächen ausgebildet sind, dass den Führungsflächen des Steckersockels innerhalb des Einbaugehäuseteils eine rückwandparallele Führung spielfrei zugeordnet ist und dass die Durchmesser der in der Leiterplatte vorgesehenen, dem Befestigen der Leiterplatte in dem Einbaugehäuseteil mittels Schrauben dienenden Durchgangsbohrungen um ein im wesentlichen der Summe der Herstelltoleranzen der zusammenzufügenden Bauteile entsprechendes Maß größer sind als die Schaftdurchmesser der verwendeten Schrauben.

Die weitere Ausgestaltung der Neuerung sieht vor, dass die Führung mittels der Rückwand und an dem Einbaugehäuseteil angebrachter Führungsleisten gebildet ist.

Ein bevorzugtes Ausführungsbeispiel ist dadurch gekennzeichnet, dass das aus Stahlblech hergestellte Einbaugehäuseteil aus einem Deckelbauteil und einem Bodenbauteil zusammengefügt ist, wobei vorzugsweise das Deckelbauteil aus einer eine Dekkelplatte, die Seitenwände und die Rückwand umfassenden Zuschnitt gebildet ist und dass wenigstens eine Führungsleiste an einer Seite der in der Rückwand vorgesehenen Aussparung angeformt ist, dass außerdem an dem Steckersockel eine der Rückwand zugeordnete Führungsfläche ausgebildet ist und dass ferner eine Führungsleiste an einer der Verbindung der Rückwand mit einer Seitenwand dienenden, an der Rückwand angeformten Platte ausgebildet ist.

Weitere Ausbildungen der Neuerung gehen aus den vorstehend nicht zitierten Unteransprüchen und der Beschreibung der Zeichnungen hervor.

Der entscheidende Vorteil, den die Neuerung bietet, ist insbesondere darin zu sehen, dass die an dem Steckersockel durch die Handhabung des Einbaugerätes beim Ein- und Ausbau sowie dem dabei erforderlichen Setzen und Ziehen von Steckern wirkenden Kräfte aufgrund der Schraubverbindungen vermeidenden, spielfreien Verbindung des Steckersockels mit dem Einbaugehäuseteil unmittelbar von dem Einbaugehäuseteil aufgenommen werden können. Anderseits ist vorteilhaft, dass die vorgeschlagene Führung des Steckersockels eine definierte Lage der Leiterplatte innerhalb des Einbaugehäuseteils bietet, wobei die Montage der Leiterplatte des vorzugsweise in einer Richtung spielfrei geführten Steckersockels weitgehend toleranzunabhängig erfolgen kann, wenn für die für die Befestigung der Leiterplatte vorgesehenen Durchgangsbohrungen ausreichend Spiel bzw. eine schwimmende Lagerung der Leiterplatte vorgesehen wird. Erwähnenswert ist außerdem, dass die vorgesehene, eine erhebliche Qualitätsverbesserung ermöglichende Lösung ohne zusätzlichen Bauteileaufwand erzielbar ist und die für den Steckersockel vorgesehene Führung im Zuge des Herstellens des Deckelbauteils im Stanz- Biege-Verfahren ausbildbar ist. Besonders wirkungsvoll ist dabei die Ausbildung derart, dass die Führung bei entsprechender Anordnung des Steckersockels auf der Leiterplatte einer Eckverbindung zwischen der Rückwand und einer Seitenwand des Deckelbauteils zugeordnet und somit die betreffende Seitenwand unmittelbar in die Kraftverteilung einbezogen wird. Ferner sei noch erwähnt, dass die gefundene Lösung keinen Raumbedarf des Steckersockels außerhalb des Einbaugehäuseteils erforderlich macht.

Im folgenden sei die Neuerung anhand der beigefügten Zeichnungen näher erläutet.

Es zeigen:
Figur 1, eine Explosionsdarstellung des Deckelbauteils, des Bodenbauteils und der mit dem Steckersockel versehenen Leiterplatte des neuerungsgemäßen Einbaugerätes,
Figur 2, eine Draufsicht der Innenseite des Deckelbauteils,

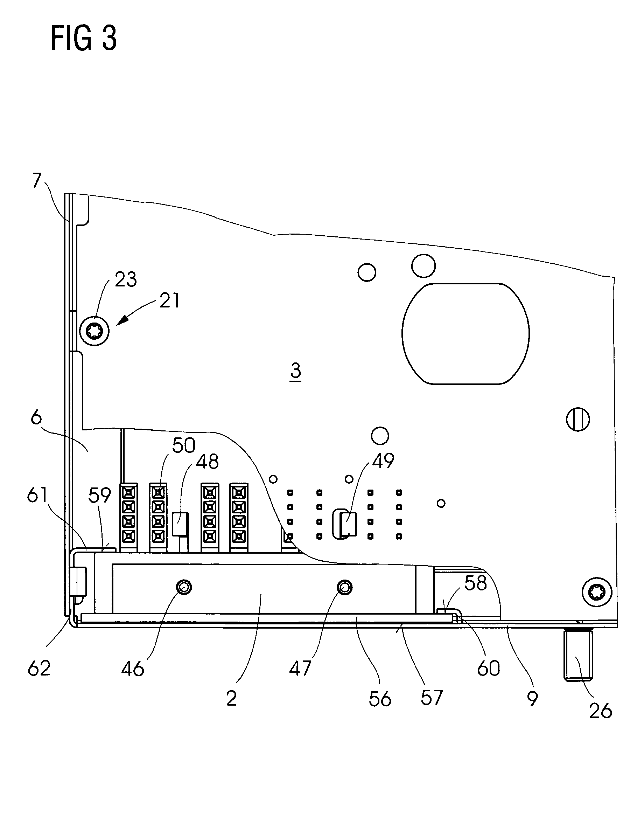

Figur 3, eine vergrößerte Teildarstellung des Einbaugerätes mit abgenommenem Bodenbauteil und einem Freischnitt der Leiterplatte.

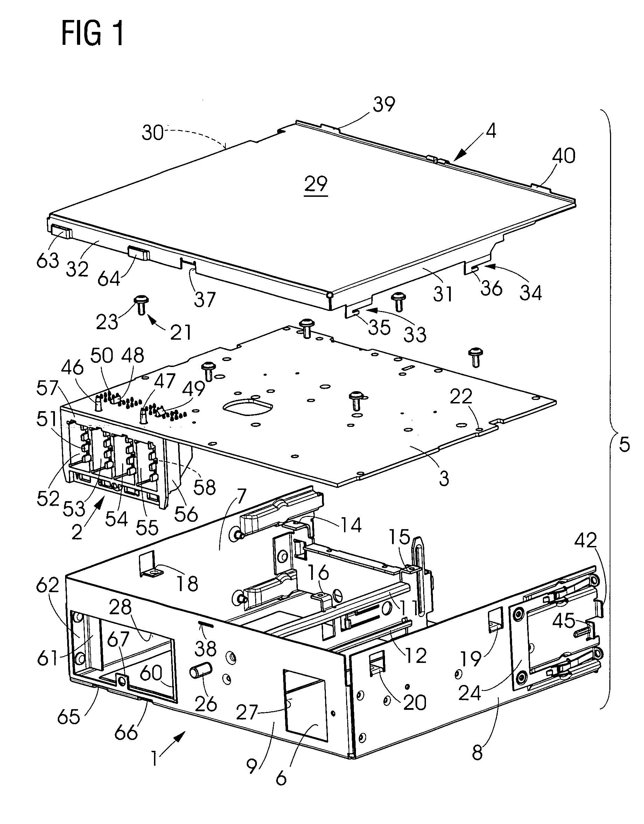

Bei der Explosionsdarstellung, Figur 1, sind ein Deckelbauteil 1, eine mit einem Steckersockel 2 versehene Leiterplatte 3 und ein Bodenbauteil 4 eines Einbaugehäuseteils 5 entsprechend der Montage des betreffenden Einbaugerätes dargestellt, während welcher zunächst das vormontierte Deckelbauteil 1 auf dessen Deckelplatte 6 vorgelegt, danach die vormontierte Leiterplatte 3 in das Deckelbauteil 1 eingesetzt und verschraubt wird, nachfolgend das Bodenbauteil 4 mittels Riegel-/ Zungenverbindungen mit dem Deckelbauteil 1 verbunden wird und abschließend eine nicht dargestellte Frontwand an dem Einbaugehäuseteil 5 angebracht, vorzugsweise mit diesem verrastet wird.

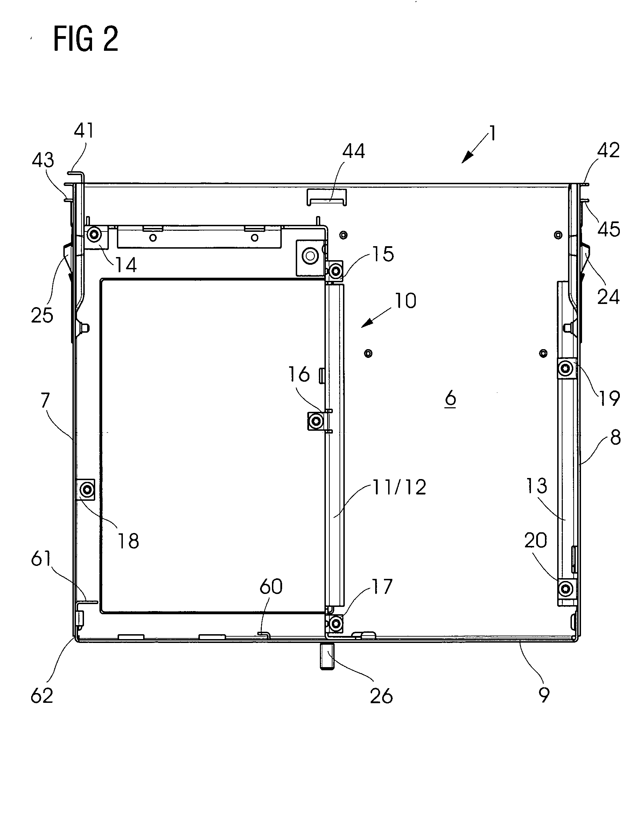

Im einzelnen ist aus der Figur 1 und aus der Draufsicht, Figur 2, ersichtlich, dass das Deckelbauteil 1 aus einem Blechzuschnitt, der die Deckelplatte 6, Seitenwände 7 und 8 sowie eine Rückwand 9 umfasst stanzbiegetechnisch gebildet ist und in geeigneter Weise, beispielweise mittels Nietverbindungen, die Seitenwände 7, 8 und die Rückwand 9 miteinander verbunden sind. Ferner ist in dem Deckelbauteil 1 ein L-förmiges Strukturteil 10 angebracht, welches einerseits als Träger für ein dem Einbaugerät zugeordnetes Display dient anderseits mittels angeformter Schienen 11 und 12 die eine Seite der Führung eines Schlittens eines in dem Einbaugerät vorgesehen Druckwerkes bildet. Die andere Seite der Führung des Schlittens bildet ein an der Seitenwand 8 angebrachtes Schienenbauteil 13. An dem Strukturteil 10, das als versteifendes/Gehäuseelement wirkt, ausgebildete Konsolen 14, 15, 16 und 17 dienen gemeinsam mit an den Seitenwänden 7, 8 ausgeformten Lappen 18, 19 und 20 der Auflage und der Befestigung der Leiterplatte 3. In den Konsolen 14, 15, 16, 17 und den Lappen 18, 19, 20 sind, den vorgesehenen, vorzugsweise selbstschneidenden Schrauben, von denen eine mit 21 bezeichnet ist, entsprechende, nicht näher bezeichnete Bohrungen angebracht. In der Leiterplatte 3 vorgesehene, den Schrauben 21 zugeordnete Durchgangsbohrungen - eine ist mit 22 bezeichnet - sind, da die Leiterplatte 3 neuerungsgemäß über eine dem Steckersockel 2 zugeordnete Führung positioniert wird, derart bemaßt, dass die Herstelltoleranzen von Leiterplatte 3 und Deckelbauteil 1 in der Leiterplattenebene wirkungslos bleiben. Dementsprechend ist es zweckmäßig den verwendeten Schrauben 21 Unterlegscheiben zuzuordnen oder zur Vereinfachung der Montage Schrauben zu verwenden, an denen eine verbreiterte Auflage 23 angeformt ist.

Der Vollständigkeit halber sei noch erwähnt, dass an den Seitenwänden 7, 8 befestigte, als u-förmige Bauteile ausgebildete, federnde Krallenpaare 24 und 25 der Befestigung des Einbaugerätes in einem Einbaufach bzw., wenn es sich bei dem Einbaugerät um einen Fahrtschreiber handelt, in einer geeigneten Öffnung in einem Armaturenbrett dienen. Ein an der Rückwand 9 des Deckelteils 1 befestigter, gegebenenfalls mit einem Gewinde versehener Bolzen 26 dient im wesentlichen der Ausrichtung und der Schwingungssicherung des Einbaugehäuses im eingebauten Zustand. Eine in der Rückwand 9 vorgesehene und mit 27 bezeichnete Öffnung dient dem Anbringen eines Batteriefachs; eine Aussparung 28 ist für den Zugang zum Stekkersockel 2 vorgesehen.

Wie aus der Figur 1 ferner ersichtlich ist, sind an einer Bodenplatte 29 des Bodenbauteils 4 seitlich und rückseitig Schenkel 30, 31 und 32 angeformt. An den Schenkeln 30, 31 ausgebildete, mit geeigneten Schlitzen 33, 34 versehene Zungen, von denen in Figur 1 zwei, 35 und 36, dargestellt sind, dienen im Zusammenwirken mit den Lappen 18, 19, 20 und der Konsole 14 dem spielfreien Verbinden des Bodenbauteils 4 mit dem Deckelbauteil 1, wobei nach einer bajonettartigen Montagebewegung zwischen dem Bodenbauteil 4 und dem Deckelbauteil 1 die Schenkel 30, 31 in das Deckelbauteil 1 eingreifen und der Schenkel 32 an der Rückwand 9 außen anliegt. Eine zusätzliche Verbindung bildet ein an dem Bodenbauteil 4 ausgebildeter Riegel 37, welcher in einen in der Rückwand 9 angebrachten Schlitz 38 eingreift. Dem Befestigen der nicht dargestellten Frontwand dienen Schnappverbindungsmittel, d.h., mit geeigneten Vertiefungen in der Frontwand zusammenwirkende Zungen von denen einige in den Figuren 1 und 2 sichtbar und mit 39, 40, 41 und 42 bezeichnet sind. Mit 43, 44 und 45 sind Lappen bezeichnet, die beim Einbau des Einbaugerätes als Anschläge dienen.

Die Verbindung des Steckersockels 2 mit der Leiterplatte 3 erfolgt mittels an dem Steckersockel 2 angeformte Ausrichtzapfen 46 und 47 sowie Rasthaken 48 und 49 letztlich aber durch Verlöten der Kontaktstifte 50 der in dem Steckersockel 2 spritzgießtechnisch eingebetteten Steckkontakten 51 mit nicht dargestellten, auf der Leiterplatte 3 angebrachten Leiterbahnen. Bei dem dargestellten Ausführungsbeispiel weist der Steckersockel 2 vier Steckerkammern 52, 53, 54 und 55 mit jeweils acht Steckkontakten 51 auf. Mit einem an dem Steckersockel 2 wenigstens teilweise umlaufenden Bund 56 sind Führungsflächen 57 und 58 ausgebildet. Eine weitere an dem Körper des Steckersockels 2 ausgebildete Führungsfläche ist mit 59 bezeichnet. Den Führungsflächen 57, 58 des Steckersockels 2 sind seitens des Einbaugehäuseteils 5 einerseits die Rückwand 9 andererseits eine aus der Rückwand 9 herausgeformte Führungsleiste 60 als Führungselemente zugeordnet. Eine weitere, die Führung des Steckersockels 2 vervollständigende Führungsleiste 61 ist an einer an der Rückwand 9 angeformten, der Verbindung der Rückwand 9 mit der Seitenwand 7 dienenden Platte 62 angebogen. Die Zuordnung der Führung des Steckersockels 2 zu einer Eckverbindung des Deckelbauteils 1 ergibt eine in besonderer Weise stabile Aufnahme des Steckersockels 2 und eine unmittelbare Kraftübertragung auf die Seitenwand 7.

Entscheidend ist, dass die vorgesehene Führung einen spielfreien Sitz des Steckersockels 2 in Richtung der Steckkontakte 51 gewährleistet. In diesem Zusammenhang ist es auch denkbar, die Leiterplatte 3 in dem Deckelbauteil 1 schwimmend zu lagern bzw. so zu befestigen, dass Relativbewegungen zwischen der Leiterplatte 3 und dem Deckelbauteil 1 möglich sind und dadurch sowohl mechanisch als auch thermisch verursachte Spannungen kompensiert werden können. Hierzu können an der Auflage der Leiterplatte 3 in dem Deckelbauteil1 mit Schlitzen versehene Kugelzapfen angeformt sein oder es können geeignete Federelemente vorgesehen werden, die die Leiterlatte 3 auf der Auflage festhalten. Erwähnt sei schließlich, dass beispielweise die Führungsleiste 60 durch wenigstens zwei voneinander getrennte Zungen gebildet werden kann. Außerdem ist es denkbar die Führungsleiste 60 bzw. die Zungen unabhängig von der Aussparung 28 aus der Rückwand herauszuformen. Mit 63 und 64 sind in dem Schenkel 32 des Bodenteils 4 ausgebildete Ösen; mit 65 und 66 in dem Deckelbauteil 1 vorgesehene Schlitze bezeichnet, die dem Anbringen einer nicht zwingend erforderlichen Abdeckhaube dienen. Um die Abdeckhaube mittels einer Schraube und einer dieser zugeordneten Plombe sichern zu können, ist an der Rückwand 9 eine mit einer Bohrung versehene Lasche 67 ausgebildet.

## Patentansprüche

1. Elektronisches Einbaugerät mit einer Frontwand und einem aus einem Deckel, einem Boden, Seitenwänden und einer Rückwand bestehenden Einbaugehäuseteil sowie mit einer quer zur Rückwand angeordneten, mit wenigstens zwei Gehäuseelementen des Einbaugehäuseteils verbundenen und die elektronischen Baugruppen und Bauteile des Einbaugerätes sowie einen Steckersockel tragenden Leiterplatte, wobei der Zugang zu den leiterplattenparallel ausgerichteten Kontakten des Steckersockels durch eine an der Rückwand des Einbaugehäuseteils vorgesehene Aussparung erfolgt,
**dadurch gekennzeichnet,**
**dass** an dem Steckersockel (2) rechtwinklig zur Richtung der Steckkontakte (51) des Steckersockels (2) Führungsflächen (57, 58, 59) ausgebildet sind,
**dass** den Führungsflächen (57, 58, 59) des Steckersockels (2) innerhalb des Einbaugehäuseteils (5) eine rückwandparallele Führung spielfrei zugeordnet ist und
**dass** die Durchmesser der in der Leiterplatte (3) vorgesehenen, dem Befestigen der Leiterplatte (3) in dem Einbaugehäuseteil (5) mittels Schrauben (21) dienenden Durchgangsbohrungen (22) um ein im wesentlichen der Summe der Herstelltoleranzen der zusammenzufügenden Bauteile entsprechendes Maß größer sind als die Schaftdurchmesser der verwendeten Schrauben (21).

2. Elektronisches Einbaugerät nach Anspruch 1,
**dadurch gekennzeichnet,**
**dass** die Führung mittels der Rückwand (9) und an dem Einbaugehäuseteil (5) angebrachter Führungsleisten (60, 61) gebildet ist.

3. Elektronisches Einbaugerät nach Anspruch 1,
**dadurch gekennzeichnet,**
**dass** das aus Stahlblech hergestellte Einbaugehäuseteil (5) aus einem Deckelbauteil (1) und einem Bodenbauteil (4) zusammengefügt ist, wobei vorzugsweise das Deckelbauteil (1) aus einem eine Deckelplatte (6), die Seitenwände (7, 8) und die Rückwand (9) umfassenden Zuschnitt gebildet ist und
**dass** wenigstens eine Führungsleiste (60) unmittelbar an der Rückwand (9) ausgeformt ist.

4. Elektronisches Einbaugerät nach Anspruch 3,
**dadurch gekennzeichnet,**
**dass** die Führungsleisten (60, 61) an gegenüberliegenden Seiten der Aussparung (28) rechtwinklig zur Befestigungsebene der Leiterplatte (3) ausgebildet sind.

5. Elektronisches Einbaugerät nach Anspruch 3,
**dadurch gekennzeichnet,**
**dass** eine Führungsleiste (61) an einer der Verbindung der Rückwand (9) mit einer Seitenwand (7) dienenden, an der Rückwand (9) angeformten Platte (62) ausgebildet ist.

6. Elektronisches Einbaugerät nach Anspruch 1,
**dadurch gekennzeichnet,**
**dass** an dem Steckersockel (2) eine der Rückwand (9) zugeordnete Führungsfläche (57) ausgebildet ist.

7. Elektronisches Einbaugerät nach Anspruch 3,
**dadurch gekennzeichnet,**
**dass** die Führungsleisten (60, 61) durch gegenüberliegend und in die Aussparung (28) hineinragend ausgebildete, wechselweise im wesentlichen rückwandeben und rückwandparallel vorgesehene Zungen gebildet sind und
**dass** an dem Steckersockel (2) dem quer zur Führungsrichtung gegebenen Abstand zwischen den Zungen entsprechende Führungsschienen ausgebildet sind.

8. Elektronisches Einbaugerät mit einer Frontwand und einem aus einem Deckel, einem Boden, Seitenwänden und einer Rückwand bestehenden Einbaugehäuseteil sowie mit einer quer zur Rückwand angeordneten, mit wenigstens zwei Gehäuseelementen des Einbaugehäuseteils verbundenen und die elektronischen Baugruppen und Bauteile des Einbaugerätes sowie einen Steckersockel tragenden Leiterplatte, wobei der Zugang zu den leiterplattenparallel ausgerichteten Kontakten des Steckersockels durch eine an der Rückwand des Einbaugehäuseteils vorgesehene Aussparung erfolgt,
**dadurch gekennzeichnet,**
**dass** an dem Steckersockel (2) rechtwinklig zur Richtung der Steckkontakte (51) des Steckersockels (2) Führungsflächen (57, 58, 59) ausgebildet sind,
**dass** den Führungsflächen (57, 58, 59) des Steckersockels (2) innerhalb des Einbaugehäuseteils (5) eine rückwandparallele Führung spielfrei zugeordnet ist und
**dass** für das Befestigen der Leiterplatte (3) auf einer wenigstens durch an den Seitenwänden (7, 8) des Einbaugehäuseteils (5) ausgebildeten Auflage (Lappen 18, 19, 20) niederhaltende, Relativbewegungen zwischen der Leiterplatte (3) und den Seitenwänden (7, 8) gestattende Mittel vorgesehen sind.
